# EUROPEAN PATENT APPLICATION

(11) **EP 4 235 773 A2**
(43) Date of publication of application: **30.08.2023**
(21) Application number: 23176249.3
(22) Date of filing: 06.09.2019
(51) Int. Cl.: H01L 23/498

(54) **CONDUCTIVE THICK FILM PASTE FOR SILICON NITRIDE AND OTHER SUBSTRATES**

(30) Priority: 07.09.2018 US 201862728382 P
(62) Divisional of application: 19858462.5
(71) Applicant: FERRO CORPORATION, Mayfield Heights, OH 44124 (US)
(72) Inventor: Kumar, Umesh, Carlsbad, 92009 (US); Maloney, John J., Solon, 44139 (US); Smith, Bradford J., Lakewood, 44107 (US); Palanisamy, Ponnusamy, Lansdale, 19446 (US); Sridharan, Srinivasan, Strongsville, 4436 (US); Sakoske, George E., Independence, 44131 (US); Graddy, George E. Jr., Del Mar, 92014 (US)
(74) Representative: Gille Hrabal Partnerschaftsgesellschaft mbB Patentanwälte

(57) **Abstract**

Conductive thick film compositions compatible to aluminum nitride, alumina and silicon nitride substrates for microelectronic circuit application. The conductive thick film composition includes first copper powder, second copper powder, and glass component. The conductive thick film composition further includes Cu₂O, Ag, and at least one metal element selected from Ti, V, Zr, Mn, Cr, Co, and Sn. After firing, the conductive thick film composition exhibit improved sheet resistivity, and improved adhesion with underlying substrate.

## Description

### FIELD OF THE INVENTION

This invention relates to lead- and cadmium- free conductive copper thick film pastes for use in producing circuits and electronic devices on aluminum nitride, alumina and silicon nitride substrates.

### BACKGROUND

The thick film circuit is one well-known form of monolithic integrated microelectronic circuit. Circuits of this type are particularly useful where a large number of passive components are required, or where moderately high power dissipation is required. Thick film circuits are less costly to produce and, depending on composition and dimensional features, can yield a broader range of resistance values than thin film circuits.

The manufacture of thick film circuits is a refinement of the well-known art of silk-screen printing. Thick film circuits consist of patterns of conductors, resistors and other passive circuit components printed on a particular substrate. In most known processes, a variety of pastes are applied onto a substrate or successive circuit layers through a screen or a template of a specific printed pattern. The successive layers are dried after printing and fired in a belt furnace to sinter the material.

In a typical thick film circuit, the substrate is often a ceramic material, such as alumina. However, for demanding applications such as in automotive electronics where extreme temperature variations are typical, other ceramic material with improved mechanical properties may be considered. In applications where the thick film circuit is formed in connection with silicon device, thermal expansion coefficient may also be important. In these applications there is much room for improvement for thick film pastes that is formed on the substrates. Thick film pastes are typically compositions of glass particles, metal and/or metal oxide particles, together with organic solvents, resins and viscosity control agents known as thixotropes. The compositions of these thick film pastes depend upon the type of passive electrical component being printed.

A variety of metal-containing thick film compositions (i.e., pastes, inks, tapes, etc.) useful in forming resistors, dielectrics and conductors which are employed in hybrid microelectronic components have been developed in the field of hybrid microelectronics. Generally, such compositions, and particularly paste or ink compositions, include a conductor (e.g., silver, palladium, copper, aluminum, gold, platinum, and the like as well as alloys of each of these different metals), resistive or dielectric components, a binder or an inorganic fluxing material, (e.g., a glass or inorganic oxides), and an organic components or vehicle comprising generally a solvent with a resin and a thixotrope and/or a wetting agent.

The above-described paste or ink compositions are applied in the desired configuration or pattern onto a suitable substrate to form the desired circuit for use as a hybrid microelectronic component.

### SUMMARY OF THE INVENTION

Conductive copper thick film pastes for use in producing circuits and electronic devices on aluminum nitride, alumina and silicon nitride substrates are described. A paste is a raw, unfired (green or "wet") mixture of glass and/or metal components together with an organic component (typically a binder or vehicle, and organic solvent).

Silicon nitride has high strength and fracture toughness even at high temperatures. Therefore, it is used as high-temperature structural components for automotive engines, gas turbines, and combustor parts.

In addition, due to its low coefficient of thermal expansion matching that of silicon, silicon nitride is ideally suited for direct bonding of silicon-based circuit devices such as insulated-gate bipolar transistors (IGBT) used as electronic switches in high power circuits. Packages of these devices often experience extreme temperature variations due to sudden changes of high electrical power. Silicon nitride's low coefficient of thermal expansion combined with high flexural strength and fairly high thermal conductivity make it suitable for applications requiring high thermal shock resistance.

As silicon nitride is a very non-reactive material, a suitable metallic conductive thick film paste composition that is available to form circuits on a silicon nitride is not known.

This disclosure provides details of screen printable metallic thick film paste compositions containing copper, silver and titanium metal powders suitable to form such circuits. Fired film showed very good electrical conductivity and adhesion to the substrate. Inkjet printing, digital printing and additive manufacturing (3D printing) application methods are also envisioned. Other processing techniques and conditions include; screen print, stencil printing, syringe deposition; One or two layers deposited by digital printing techniques; Firing atmospheres including ambient, Helium, Argon, Xenon, Neon, Krypton, Nitrogen (N₂) and combinations thereof. Layers may be fired individually or together. Multiple firings may be undertaken to build thickness of a finally fired component. Layers may be co-fired (1, 2, 3, or more).

In addition to silicon nitride (SiNx or Si₃N₄) substrates, the present subject matter applies to AIN as well. Other substrates of interest include AIN, SiON, BN, and Alumina.

The products of the invention may be used in MLCCs, LTCC, capacitors, resistors, cellular phones, computers, computer components, stereophonic equipment, home appliances, automotive components, televisions and other electronic products.

Alloys containing Ag, Cu and Ti metal powders were identified as suitable candidates to bond Silicon nitride to other materials such as Silicon, stainless steel etc. These compositions are very fluid just above the melting point. Moreover, they are used only in vacuum or in Argon (inert) atmosphere.

To form a thick film circuit, dried screen-printed patterns are fired in a belt furnace either in air or in N₂ atmosphere. Any composition that contains Cu as a part of conductor is fired in N₂ atmosphere. Industrial standard for thick film processing is 850-900°C. After firing, pattern dimensions in x-y directions should not change. The fired film should densify and bond very well to the substrate. If the formulation is intended for good electrical conductivity, the resistivity should be as low as possible, typically a few milli-ohms per square.

Considering these objectives, several compositions with Ag, Cu, and Ti powders were tested. Individual metal powder concentrations away from the eutectic region were selected to control the amount of liquid formation at 875-900°C. Compositions suitable for firing at 875-900°C in N₂ atmosphere with good adhesion and low electrical resistivity were identified.

After firing, the fired surface did not show very good solder wetting. To improve the soldering, another copper paste with suitable glass was applied as top layer. The resistivity and adhesion data was collected with the two layer structure.

Within the knowledge of the inventors, the bonding operation is carried out either in vacuum or in an inert atmosphere such as Argon. Typical active metal brazing alloy compositions are made with Ag-Cu eutectic with small amounts of active metal such as Ti.

In one aspect, the present subject matter provides a lead-free and cadmium-free conductive thick film paste, comprising 20-40 wt.% first Cu (copper metal), 20-23 wt.% second Cu (copper metal), 3-12 wt.% Cu2O, 0.01-25 wt.% Ag, 0.01-25 wt.% of at least one metal element selected from Ti, V, Zr, Mn, Cr, Co, and Sn, and 5-20 wt.% organic component. The first Cu has a D50 particle size in microns about 2-12, 3-11, 4-10, 5-9, 6-8 and ranges not specified that are between values selected from the ranges in this sentence. In other embodiments, the first Cu has a D50 particle size in microns of about 0.01-8, 0.01- 5, or 0.5 to 3 or ranges not specified that are between values selected from the ranges in this sentence. A second Cu has a D50 particle size in microns in the range of about 12-30, 14-27, 16-25, 17-24, 18-23, 19-22, 20-21 and ranges not specified that are between values selected from the ranges in this sentence. In other embodiments, the second Cu has a D50 particle size in microns of about 0.01-8, 0.01- 5, or 0.5 to 3 or ranges not specified that are between values selected from the ranges in this sentence.

A second Cu has a D50 particle size in microns in ranges of about 12-30, 14-27, 16-25, 17-24, 18-23, 19-22, 20-21 and ranges not specified that are between values selected from the ranges in this sentence. A paste is an unfired composition.

In another aspect, the present subject matter provides a lead-free and cadmium-free conductive thick film paste including a glass component and a copper (Cu) component. The glass component includes 15-65 wt.% alkaline earth oxide, 0.01-10 wt.% alkali oxide, 22-70 wt.% (B₂O₃+SiO₂), and 0.01-15 wt.% Al₂O₃. The alkaline earth oxide is selected from the group consisting of MgO, CaO, SrO, BaO, and ZnO. The alkali oxide is selected from the group consisting of Li₂O, Na₂O, K₂O, and Rb₂O.

In yet another aspect, the present subject matter provides a method of forming a conductive thick film on a substrate. The method includes applying at least one layer of a first conductive thick film paste and a second conductive thick film to form a conductive thick film on the substrate. The first conductive thick film paste includes in wt.% 20-40 wt.% first Cu, 20-23 wt.% second Cu, 3-12 wt.% Cu₂O, 0.01-25 wt.% Ag, 0.01-25 wt.% at least one metal element selected from Ti, V, Zr, Mn, Cr, Co, and Sn, and 12-20 wt.% organic component. The first Cu has a D50 particle size in microns about 2 up to12, 3-11, 4-10, 5-9, 6-8 and ranges not specified that are between values selected from the ranges in this sentence. A second Cu has a D50 particle size in microns about 12-30, 14-27, 16-25, 17-24, 18-23, 19-22, 20-21 and ranges not specified that are between values selected from the ranges in this sentence. The second conductive thick film paste includes a glass component and a copper (Cu) component. The glass component includes 15-65 wt.% alkaline earth oxide, 0.01-10 wt.% alkali oxide, 22-70 wt.% (B₂O₃+SiO₂), and 0.01-15 wt.% Al₂O₃. The alkaline earth oxide is selected from the group consisting of MgO, CaO, SrO, and BaO. ZnO may be included in the alkaline earth oxide component. Oxides of Ca, Ba, and Zn are preferred, and oxides of Ca and Zn are most preferred. The alkali oxide is selected from the group consisting of Li₂O, Na₂O, K₂O, and Rb₂O and combinations thereof. The method further includes drying the first and second conductive thick film pastes on the substrate. The method further includes firing the dried first conductive thick film paste and the dried second conductive thick film paste to form the fired conductive thick film on the substrate. The substrate is selected from the group consisting of aluminum oxide, aluminum nitride, silicon nitride, and boron nitride.

In still yet another aspect, the present subject matter provides an electronic device including a substrate, and a fired conductive thick film disposed on at least a portion of the substrate. The fired conductive thick film includes at least one first fired conductive thick film and one second fired conductive thick film. The substrate is selected from the group consisting of aluminum oxide, aluminum nitride, and silicon nitride. The first fired conductive thick film includes the conductive thick film paste including 20-40 wt.% first Cu, 20-23 wt.% second Cu, 3-12 wt.% Cu₂O, 0.01-25 wt.% Ag, 0.01-25 wt.% at least a metal element selected from Ti, V, Zr, Mn, Cr, Co, and Sn, and 12-20 wt.% organic component. The first Cu has a D50 particle size in microns about 2-12, 3-11, 4-10, 5-9, 6-8 and ranges not specified that are between values selected from the ranges in this sentence. A second Cu has a D50 particle size in microns about 12-30, 14-27, 16-25, 17-24, 18-23, 19-22, 20-21 and ranges not specified that are between values selected from the ranges in this sentence. The second fired conductive thick film includes the conductive thick film paste including a glass component and a copper (Cu) component. The glass component includes 15-65 wt.% alkaline earth oxide, 0.01-10 wt.% alkali oxide, 22-70 wt.% (B₂O₃+SiO₂), and 0.01-15 wt.% Al₂O₃. The alkaline earth oxide is selected from the group consisting of MgO, CaO, SrO, BaO, and ZnO. The alkali oxide is selected from the group consisting of Li₂O, Na₂O, K₂O, and Rb₂O.

The foregoing and other features of the subject matter invention are hereinafter more fully described and particularly pointed out in the claims, the following description setting forth in detail certain illustrative embodiments of the subject matter, these being indicative, however, of but a few of the various ways in which the principles of the present subject matter may be employed.

### BRIEF DESCRIPTION OF THE DRAWINGS

FIG. 1 is SEM picture and EDS mapping of the fired PASTE A on silicon nitride.
FIG. 2 is a SEM picture and EDS mapping of the fired PASTE A on aluminum nitride.

### DETAILED DESCRIPTION OF THE INVENTION

The present invention provides a lead-free and cadmium-free conductive thick film paste, which contains copper, for use in producing hybrid microelectronic components across a wide temperature range. This thick film paste including copper is formed on aluminum oxide, aluminum nitride, and silicon nitride without suffering sintering and includes a glass component that flows at relatively low firing temperatures.

The automotive industry, the optoelectronics industry, or military requires a plurality of silicon based circuit devices in the electronic systems. One of the silicon based circuit devices include, for example, an insulated-gate-bipolar-transistors (IGBT) used as electronic switches in high power circuits. The electronic systems including the IGBT from time to time requires experiencing extreme temperature variations due to sudden changes of high electric power. IGBTs are fabricated on a ceramic substrate such as aluminum oxide (alumina) and aluminum nitride. A thin layer of copper is metallized on the alumina substrate.

In addition to the ceramic substrates currently in use, order to further provide reliability of minimize interaction with resistors fired or prefired at 900 °C or greater, thus minimizing shifts in the thermal coefficient of resistance (TCR) and resistivity, it is preferable to fire these new conductors at a lower temperature, for example about 750°C or lower, about 700°C or lower, or most preferably about 650°C or lower. Practical lower limits to such firing temperatures are known to the skilled artisan. Other applications will require firing at about 800 °C or about 850°C. Hence, the inventive thick films with a wide processing window (650-850°C) have an advantage over the prior art. The inventive thick films possess additional desirable characteristics such as good solderability (i.e., excellent solder wetting), good wire bondability, low resistivity, and provide excellent adhesion to a variety of substrates, including 96% alumina and glass coated stainless steel substrates, as well as low resistivity, and a microstructure after firing that is dense and substantially free of pores.

Copper is an ideal conductor material for thick film and power electronic applications because it has a high electrical conductivity, high thermal conductivity, resists solder leaching, and resists electro migration much better than other conductors such as silver, and can handle a high current density. Prior art low-temperature firing copper thick film systems exhibit minimal adhesion to common substrates, poor solderability and often contain undesirable metals such as lead or cadmium.

As has been stated, the inventive paste compositions are conductive. While the line between conductors and resistors is often unclear, the paste compositions of the present invention have a sheet resistivity of about 2.1-3.1 miliohm / sq / mil. And maximum resistivity of about 20 milliOhms per square (mOhm/square).

The present subject matter also provides an electronic device having a lead-free and cadmium-free conductive thick film applied thereto and fired to form an electrical circuit. Electronic devices upon which the lead-free and cadmium-free conductive thick film can be applied and fired include direct bonding of silicon based circuit devices such as insulated-gate-bipolar-transistors (IGBT), which is used as electronic switches in high power circuits. Throughout the instant specification and in the appended claims, the term "electronic device" means any electronic device that includes thick film and/or hybrid thick film circuitry that would survive at least the firing temperatures disclosed herein and benefit from the conductive circuitry provided by the lead-free and cadmium-free thick film paste composition.

In general, the present subject matter provides a lead- and cadmium-free conductive thick film pastes having at least Cu a metal component and a glass component. The metal component comprises copper. The glass component comprises a first glass and a second glass, and is free of lead, cadmium and compounds of lead and cadmium.

The lead-free and cadmium-free conductive thick film paste of the present subject matter is generally applied to a surface of an electronic device upon which has been formed one or more circuits or other electronic components (e.g., transistors, capacitors, and resistors). The conductive thick film paste is preferably dried and fired, as is more thoroughly described below, to form a lead and cadmium free electrical circuit on the substrate. As used throughout the instant specification and the appended claims, the phrase "lead-free and cadmium-free" means that no lead, or PbO, cadmium, or CdO, has been intentionally added to the composition, and that the composition comprises less than about 0.1% by weight Pb or Cd after firing.

In particular, the inventive conductive thick film paste may be applied to a substrate by means of screen printing, syringe deposition, and digital printing technique. The paste may contain an organic components or vehicle, providing appropriate viscosity in order to pass through the screen. The paste may also contain a thixotropic material in order to set up rapidly after being screened to give good resolution. While the rheological properties are of primary importance, the organic components is preferably formulated also to give appropriate wettability of the solids and the substrate, good drying rate, dried film strength sufficient to withstand rough handling, and good firing properties. Satisfactory appearance of the fired composition is also important.

In view of all of the foregoing criteria, a wide variety of inert liquids may be used in the organic components. The organic components for most conductive thick film pastes is typically a solution of a resin dissolved in a solvent and, frequently, a solvent solution containing both resin and a thixotropic agent. The solvent usually boils within the range of about 130°C to about 350°C. The most frequently used resin for this purpose is ethyl cellulose. However, resins such as ethyl hydroxy ethyl cellulose, wood rosin, mixtures of ethyl cellulose and phenolic resins, polymethacrylates of lower alcohols and monobutyl ether of ethylene glycol monoacetate can also be used. The most widely used solvents for thick film applications are terpenes such as alpha- or beta-terpineol or mixtures thereof with other solvents such as kerosene, dibutyl phthalate, butyl carbitol, butyl carbitol acetate, hexylene glycol, texanol, and high-boiling alcohols and alcohol esters. Various combinations of these and other solvents formulated to obtain the desired viscosity and volatility requirements for each application.

Among commonly used thixotropic agents are organic based thixotropes such as, for example, hydrogenated castor oil and derivatives thereof. It is of course, not always necessary to incorporate a thixotropic agent because the solvent/resin properties coupled with the sheer thinning inherent in any suspension may alone be suitable in this regard. Furthermore, a wetting agent may be employed such as fatty acid esters, e.g., N-tallow-1,3-diaminopropane di-oleate, N-tallow trimethylene diamine diacetate, N-coco trimethylene diamine, beta diamines, N-oleyl trimethylene diamine, N-tallow trimethylene diamine, and/or N-tallow trimethylene diamine dioleate.

The ratio of organic components to solids in the inventive conductive compositions may vary considerably and is dependent upon the manner in which the conductive compositions are to be applied and the type of organic components used. Normally to achieve good coverage, the conductive composition may contain by weight 60-90% solids and 40-10% of a liquid organic components. Such conductive compositions are usually of semi-fluid consistency and are referred to commonly as "pastes."

For the purposes of the present subject matter, the first conductive thick film paste preferably contains from about 75% to about 94% by weight solids and from about 6 to about 25% by weight of the liquid organic components. Furthermore, the preferred ranges of components in the solids portion for the first conductive thick film paste according to the present subject matter is as follows (Table 1) : a) a first copper, preferably from about 20.0 to about 40.0 %, more preferably from about 20.0 to about 36.0 %, most preferably from about 23.0 to about 29.0 % of the first conductive thick film paste; b) a second copper, preferably from about 20.0 to about 36.0 %, more preferably from about 20.0 to about 30.0 %, most preferably from about 20.0 to about 25.0 % of the first conductive thick film paste; c) cuprous oxide (Cu₂O) comprising, preferably from about 0.01 to about 12.0 %, more preferably from about 4.0 to about 12.0 %, most preferably from about 4.0 to about 9.0 % of the first conductive thick film paste; d) silver (Ag), preferably from about 0.01 to about 25.0 %, more preferably from about 2.0 to about 20.0 %, most preferably from about 8.0 to about 17.0 % of the first conductive thick film paste; e) at least a metal element, preferably from about 0.01 to about 25.0 %, more preferably from about 1.0 to about 20.0 %, most preferably from about 10.0 to about 16.0 % of the first conductive thick film paste. The at least one metal element is selected from the group consisting of Ti, V, Zr, Mn, Cr, Co, and Sn. In a preferred embodiment, the at least one metal element is selected from the group selected from Ti, V, Zr, Cr, and Sn. In a more preferred embodiment, the at least a metal element is selected from the group selected from Ti, and Sn. In a most preferred embodiment, the at least a metal element is Ti.

**Table 1. Solid portion of first conductive thick film paste**

| Composition | Preferred | More Preferred | Most Preferred |
|---|---|---|---|
| First Cu | 20-40 | 20-36 | 23-29 |
| Second Cu | 20-36 | 20-30 | 20-25 |
| Cuprous oxide (Cu₂O) | 0.01-12 | 4-12 | 4-9 |
| Silver (Ag) | 0.01-25 | 2-20 | 8-17 |
| Metal element | 0.01-25 | 1-20 | 10-16 |

With respect to the organic components, it is found that the preferred composition according to the present invention is as follows: 1) at least about 90 percent by weight organic solvent; 2) up to about 15 percent by weight resin; 3) up to about 4 percent by weight thixotropic agent; and 4) up to about 2 percent by weight wetting agent. Exemplary vehicles are EV2803, 235 and No flow m7 all available from Ferro Corporation which consist of ethyl cellulose dissolved in Terpineol and Texanol. The copper metal is advantageously provided in the form of powders and/or flakes.

For the purposes of the present subject matter, the second conductive thick film paste preferably contains from about 70% to about 94% by weight solids and from about 8 to about 30% by weight of the liquid organic components. Furthermore, the preferred ranges of components in the solids portion for the second conductive thick film paste according to the present subject matter is as follows (Table 2) : a) a first copper, preferably from about 14 to about 23%, more preferably from about 15 to about 23%, most preferably from about 17 to about 22% of the second conductive thick film paste; b) a second copper, preferably from about 20 to about 28%, more preferably from about 22 to about 28%, most preferably from about 23 to about 26% of the second conductive thick film paste; c) a third copper, preferably from about 15 to about 24%, more preferably from about 15 to about 24%, most preferably from about 18 to about 24% of the second conductive thick film paste; and d) cuprous oxide (Cu₂O) comprising, preferably from about 0.1 to about 11%, more preferably from about 6 to about 10%, most preferably from about 7 to about 10% of the second conductive thick film paste.

**Table 2. Solid portion of second conductive thick film paste**

| Composition | Preferred | More Preferred | Most Preferred |
|---|---|---|---|
| First Cu | 14-23 | 15-23 | 17-22 |
| Second Cu | 20-28 | 22-28 | 23-26 |
| Third Cu | 15-24 | 15-24 | 18-24 |
| Cuprous oxide (Cu₂O) | 0.1-11 | 6-10 | 7-10 |

The solids portion for the second conductive thick film paste also includes the glass component usually provided initially in the form of one or more glass powders. In one embodiment, the present subject matter provides a conductive thick film paste, said paste including a Pb- and Cd- free glass component, said glass component comprising in mole%: about 15 to about 65% alkaline earth oxide, about 0.01 to about 10% alkali oxide, about 22 to about 70% (B₂O₃ + SiO₂), and about 0.01 to about 15% Al₂O₃. At least one alkaline earth oxide is selected from MgO, CaO, SrO, BaO, and ZnO. In a preferred embodiment, at least one alkaline earth oxide is selected from MgO, CaO, and ZnO. In a most preferred embodiment, at least one alkaline earth oxide is selected from CaO, and ZnO. At least one alkali oxide is selected from Li₂O, Na₂O, K₂O, and Rb₂O.

It should be kept in mind that the foregoing compositional ranges are preferred and it is not the intention to be limited to these ranges where one of ordinary skill in the art would recognize that these ranges may vary depending upon specific applications, specific components and conditions for processing and forming the end products. For each disclosure of a numerical range bounded by zero at the lower end, the disclosure is also read as having a value of 0.01 or 0.1 at the lower end.

The paste according to the present invention may be conveniently prepared on a three-roll mill. The amount and type of organic components utilized are determined mainly by the final desired formulation viscosity, fineness of grind of the paste, and wet print thickness. In preparing compositions according to the present subject matter, the particulate inorganic solids are mixed with the organic components and dispersed with suitable equipment, such as a three-roll mill, to form a suspension, resulting in a composition for which the viscosity will be in the range of about 50 to about 200 kcps, preferably about 100 to about 150 kcps, at a shear rate of 9.6 sec⁻¹ as determined on a Brookfield viscometer 2HBT, spindle CP-51, measured at 25°C.

The circuit substrates according to the present subject matter are preferably produced by applying the first conductive thick film paste of the present subject matter to a substrate, usually by the process of screen printing, to a desired wet thickness, e.g., from about 60 to about 80 microns. Automatic screen printing techniques can be employed using a 80-325 mesh screen. The printed pattern is then dried at below 200°C, e.g., preferably at about 175°C for about 20-40 minutes. Subsequently, the second conductive thick film paste of the present subject matter is applied to the top of the dried first conductive thick film paste. The printed pattern is then dried at below 200°C, e.g., preferably at about 175°C for about 20-40 minutes before firing. The glass is fused and the metal is sintered in a controlled, non-oxidizing atmosphere belt conveyor furnace. The firing is generally done according to a temperature profile that will allow burnout of the organic matter at about 300°C to about 550°C, a period of peak temperature of about 850°C to about 1050°C, lasting about 5-15 minutes, followed by a controlled cool-down cycle to prevent over-sintering, unwanted chemical reactions at intermediate temperatures or substrate fracture, which can occur when the substrate cools too quickly. A non-oxidizing atmosphere such as nitrogen, argon or mixtures thereof is used to prevent oxidation of metal, especially copper, which tends to oxidize in air even at room temperature. For the purposes of the present invention a nitrogen atmosphere is preferred. For example, the amount of oxygen in nitrogen may be preferably controlled to lower than 10 ppm. The overall firing procedure will preferably extend over a period of about 60 to 85 minutes, with about 25 to 30 minutes to reach the firing temperature, about 5 to 15 minutes at the firing temperature, and about 30 to 40 minutes in cool down.

An exemplary firing cycle is, assuming room temperature of 20°C, ramp up at about 30°C/min to a peak temperature of 900°C, holding at 900°C for 12 minutes, and cooling at 60°C/min for about 15 minutes to exit the furnace at about 60°C.

The following examples are intended only to illustrate the invention and should not be construed as imposing limitations upon the claims. The following experimental methods, conditions and instruments were employed in preparing the exemplary pastes detailed hereinbelow.

### Conductive thick film pastes

Conductive thick film pastes include the first conductive thick film paste and the second conductive thick film paste. In one embodiment, the first conductive thick film paste is formed directly on the top of the substrate, and the second conductive thick film paste is formed directly on the top of the first conductive thick film paste, where the first conductive thick film paste is in a dry state.

First conductive thick film paste was made by mixing appropriate amounts of copper powders with two (2) different particle sizes, silver powders, cuprous oxide (Cu₂O) powders, at least a metal element, Boric acid, Triton X-100, Ethanox 702 with organic vehicles, first in a planetary mixer for homogenization, and next in a three-roll mill to achieve a fineness of grind of less than 50, preferably <40, more preferably <30, still more preferably <20, even more preferably < 10 µm.

Second conductive thick film paste was made by mixing copper powders with three (3) different particle sizes, Cu₂O powders, and glass powders, boric acid, Triton X-100, Ethanox 702 with organic vehicles, first in a planetary mixer for homogenization, and next in a three-roll mill to achieve a fineness of grind of less than 20 µm. The viscosity of the first and second conductive thick film pastes was measured with a Brookfield HBT viscometer 2HB, 2.5 rpm at 25 °C using spindle CP-51. Shelf life of the green pastes is good.

### Glasses

The second conductive thick film paste includes Pb free and Cd free glass powder. The glass powder formulation includes about 15-65% of alkaline earth oxide, about 0.01-10 wt.% of alkali oxide, about 22-70 wt.% of (B₂O₃+SiO₂), and about 0.01-15 wt.% of Al₂O₃. The alkaline earth oxide is one or more selected from the group consisting of MgO, CaO, SrO, BaO, and ZnO. The alkali oxide is one or more selected from the group consisting of Li₂O, Na₂O, K₂O, and Rb₂O. Suitable commercially available glasses from Ferro Corporation include, EG0026, EG0028, EG2807, EG3046, LF256; EG2810, BBS2.

### Copper powder

The metal component comprises copper metal. Copper metal typically is provided in the form of at least one of powder and/or flakes. Copper powders may have a plurality of copper powders having different particle size distribution and/or particle morphology. In particular, more than one size range of copper particles may be used for the first and second conductive thick film pastes, respectively. For example, for the first conductive thick film paste, the copper powder may include a first copper powder having D50 of about 5 micron, and a specific surface area (SSA). The first copper powder is sold under the name ICP UF-5-AC, and available from Makin-UK. A second copper powder has D50 of about 0.3-0.5 micron. The second copper powder is sold under the product name CU-F400 available from CNPC.

For the second conductive thick film paste, the copper powder may include a first copper powder having D50 of about 5 micron. The first copper powder is sold under the name ICP UF-5-AC, and available from Makin-UK. A second copper powder has D50 of about 1.5 micron, and specific surface area (SSA) of 0.65 m²/g. The second copper powder is sold under Cu 22-201, and available from Technic Corporation. A third copper powder has D50 of about 10 micron. The third copper powder is sold under Cu-APC0412000CX00, and available from Safina Corporation.

### Other metals and oxides

The first conductive thick film includes flake shaped silver (Ag) powder with D50 of less than 9 micron. The specific surface area (SSA) ranges 0.65-1.35 m²/g. The Ag powder is sold under Silver Flake SF-4, available from Ames Corporation. The Titanium (Ti) powder has D100 of less than 20 micron, and is sold under Ti-101, available from AEE Corporation. Commercially available Cuprous oxide (Cu₂O) is used in forming both the first and second conducive thick films.

### Method

Substrates: The substrates used were: (1) silicon nitride (Maruwa, Japan), (2) aluminum nitride (Maruwa, Japan), and (3) 96% alumina (CoorsTek, USA).

Screen printing: The first conductive thick film pastes were screen printed on the substrates using 80 mesh screens and a pattern appropriate for testing resistivity and adhesion. The printed pastes are dried in a box oven at 175°C for 30 minutes. Subsequently, the second conductive thick film pastes were screen printed on the dried first conductive thick film pastes using 80 mesh screens and a pattern appropriate for testing resistivity and adhesion. The printed second conductive thick film pastes are dried in the box oven at 175°C for 30 minutes. The thickness of the green screen-printed paste was about 80-120 µm and upon drying decreased to 50-65 µm. Other thicknesses are possible in various embodiments, such as green thicknesses in microns of 10-50 (with 325 mesh screen), 70-130, 75-125, 85-115, 90-110, 95-105, and ranges not specified that are between values selected from the ranges in this sentence. Other possible fired thicknesses in various embodiments such as fired thicknesses in microns of 5-25, 40-90, 45-85, 50-80, 55-75, 60-70, and ranges with upper and lower bounds selected from the ranges in this sentence.

Firing profile and conditions: A belt furnace was used, with a belt speed of 1.88 inches (4.78 cm) per minute. The sample was heated to peak temperature over the course of 28 minutes. The sample was held at the peak temperature for 10-30 minutes. The sample was cooled at a controlled rate to about 60°C, this cooling requiring about 38 minutes. Samples were fired in a nitrogen atmosphere having less than 10 ppm O₂. Peak temperature was 650°C, or 1050°C, or other values in between.

Testing performed included electrical characteristics, initial adhesion to substrate, and aged adhesion to substrate. Electrical testing included determination of resistivity, expressed in mOhm/square, calculated from the measured resistance of a serpentine pattern that is 500 micron wide having 200 squares and a fired thickness of about 30 µm, then normalized to 25.4 µm.

Adhesion was measured by dip soldering, in which a 22 AWG Cu-Sn wire was soldered to a 0.080" by 0.080" square pad using 62Sn/36Pb/2Ag solder and KESTER^{®} RMA solder flux 197. KESTER^{®} is the registered trademark of Kester Solder, Des Plaines, III. 60018-2675. The wires were then pulled at 90° to failure using the Shepard Crook method. Adhesion strength was expressed as pounds of force needed to break the wire. Aged adhesion was measured after subjecting the soldered joint to a temperature of 150°C for 48 hours.

After firing at temperatures set forth above, an interface between the substrate and the fired conductive thick film was examined by scanning electron microscope (FEI-Quanta FEG 450) for determine the nature of bonding. The chemical mapping of the substrate and the conductive thick film was performed by energy dispersive spectroscopy (Oxford X-max 50). In particular, chemical mapping for Ti and N was recorded for the cross-section of the conductive thick film formed on the substrate.

The interfacial SEM and the chemical mapping for Ti and N₂ are reproduced below.

### On Silicon Nitride : EDS signals

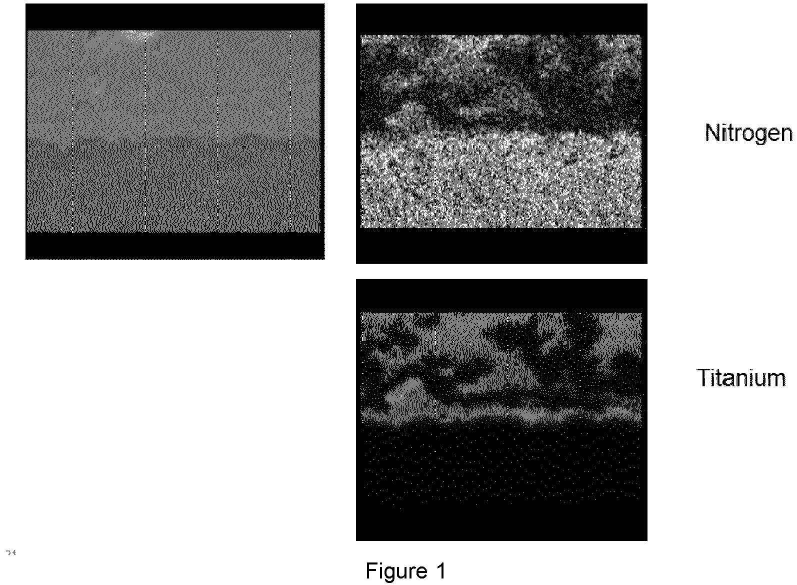

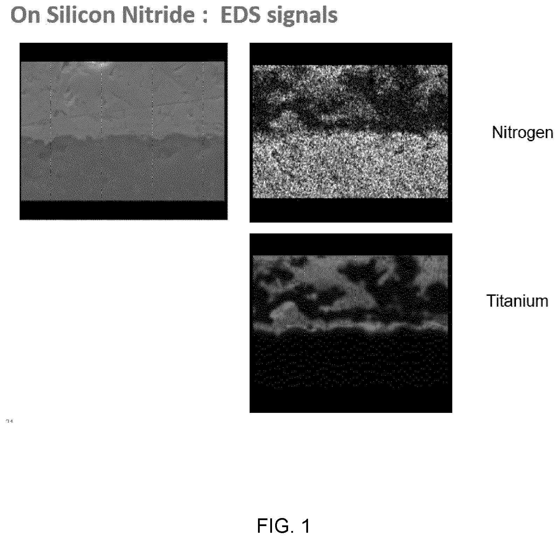

Fig.1. SEM/EDS observation on Silicon Nitride/Paste A interface

Fig. 1 shows that Ti is detected as a continuous layer at the interface, and indicates an interfacial reaction and bonding to the substrates.

Additionally, the paste combination was tested on Aluminum Nitride substrate. As recorded in Table 4, very good electrical conduction and adhesion were observed. Interfacial analysis through SEM/EDS showed the reaction zone very clearly.

### On Aluminum Nitride: EDS signals

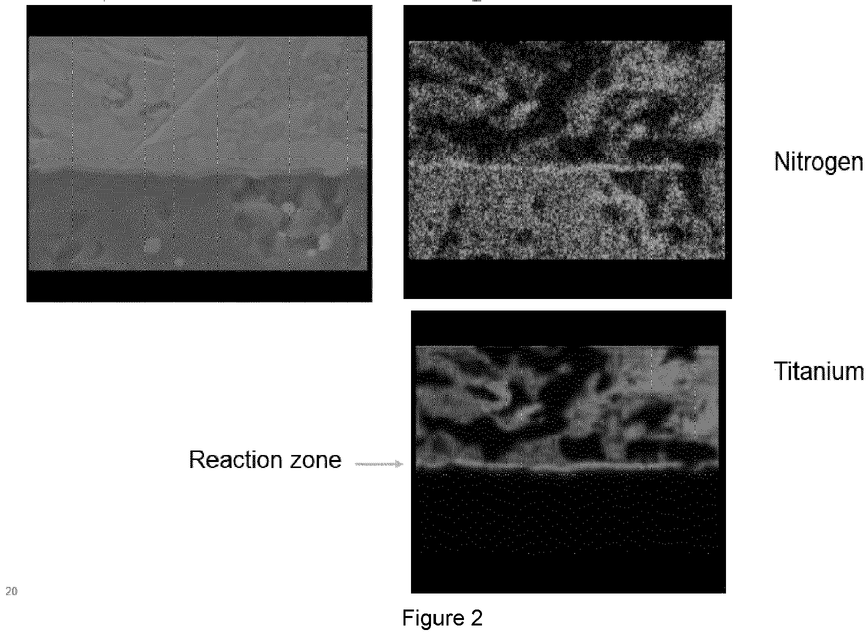

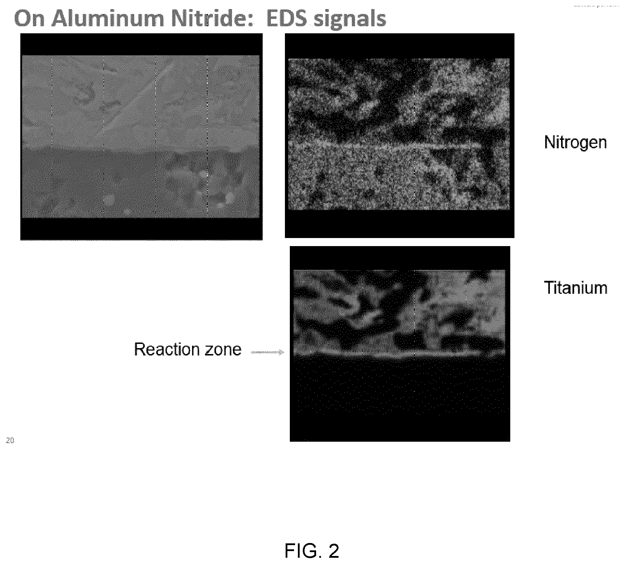

Fig 2. SEM/EDS observation on Aluminum Nitride/Paste A interface

In each of Figures 1 and 2, the fired paste is above the reaction zone, and the substrate is below the reaction zone.

**Example 1.** The compositions of inventive thick film pastes, paste A, paste B, and paste C are described in Table 3. Silicon nitride and aluminum nitride were used as substrates. Either paste A or paste B is formed directly on the substrate as an adhesion layer. After either paste A or paste B is dried, Paste C is formed on the either paste A or paste B. It is noted that the detailed composition of paste A and paste B are slightly different from each other to tailor the adhesion of Cu thick film on the substrate. After paste C is dried, the dried conductive thick film stack was fired in a N₂ atmosphere at 900°C. Selected electrical and mechanical properties of the stack including paste C on paste A, after firing on silicon nitride and aluminum nitride, are shown in Table 4. Typically, an aged adhesion of at least 3 pounds of force is considered to be acceptable for thick films formed on a substrate. Aged adhesion was above the acceptable level, and was in the range of 5-6 pounds force, which is promising for use for an extended period. Sheet resistivity of the fired conductive thick film was in the range of 2.1 to 3.1 mOhm/square. Considering that typically 1-5 mOhm/square is considered to be a good conductor, it is expected that the conductive thick film according to the present subject matter would work as thick film circuitry on silicon nitride and aluminum nitride.

**Table 3. Compositions for Pastes A, B, and C**

| | Pastes | | |
|---|---|---|---|
| Ingredients | A | B | C |
| First Cu powder | 23-29 | 23-29 | 14-23 |
| Second Cu powder | 20-25 | 20-25 | - |
| Second Cu powder | - | - | 20-28 |
| Third Cu powder | - | - | 15-24 |
| Cuprous oxide (Cu₂O) | 4-9 | 4-9 | 5-11 |
| Ag | 8-17 | 8-17 | - |
| Metal element | 10-16 | 10-16 | - |
| Glass | - | - | 1-10 |
| Boric acid | 0.60 | 0.60 | 0.68 |
| Triton X-100 | 1.40 | 1.40 | 1.49 |
| Irganox 1076 | | | 0.10 |
| Ethanox 702 | 0.40 | 0.40 | |
| No flow m7 | 8.20 | 7.70 | 8.69 |
| Vehicle EV2803 | - | - | 0.60 |
| Vehicle 235 INT | 6.40 | 7.50 | 9.07 |
| Hexylene Glycol | 0.30 | 0.20 | 0.48 |
| Texanol | - | - | 1.48 |

**Table 4. Electrical and Mechanical Properties for the conductive thick film stack (paste C on paste A) after sintering**

| Thick film stack (paste C/Paste A/substrate) | | |
|---|---|---|
| Substrate | Silicon Nitride | Aluminum Nitride |
| Sheet resistivity (mOhm/square) | 2.1 | 3.1 |
| Initial adhesion (lb. force) | 3.1 | 7.2 |
| Aged adhesion (lb. force) | 5.3 | 5.8 |

**Example 2.** The inventive thick film pastes B and C in Table 3 were selected to form a thick film stack. Silicon nitride, aluminum nitride, and alumina were used as substrates. Thick film pastes B and C are formed on each substrate such that the paste B is in direct contact with the substrate. After paste B is dried at a similar temperature as paste A in Example 1, paste C is formed on the paste B and dried. The thick film stack was fired in an N₂ atmosphere at 900°C. Selected electrical and mechanical properties of the fired conductive thick film stack are shown in Table 5. Sheet resistivity of the fired conductive thick film was, regardless of the substrate used, in the range of 3.0 and 3.1 mOhm/square, and was in acceptable range as electrically conductive circuitry. Both initial adhesion and aged adhesion were also measured to be far above the typical standard of at least 3 pounds of force. In particular, the conductive thick film stack according to the present subject matter showed improved adhesion (both initial and aged) on silicon nitride substrate over other substrates including aluminum nitride and alumina.

The various powders and components of the inventive are commercially available and have the following identities.

| | |
|---|---|
| | |

| **Cu powders** | **Manufacturer** |
|---|---|
| ICP UF-5-AC Cu Powder | Makin - UK |
| Cu 22-101 | Technic |
| Cu - APC0412000CX00 | Safina |
| Cu F-400 | CNPC |

| **Silver** | |
|---|---|
| Silver Flake SF-4 | Ames |
| | |

| **Titanium** | |
|---|---|
| Ti-101 | AEE |
| | |

| **Oxide and Glasses** | |
|---|---|
| ER 118 | JT Baker/Avantar |
| EG-0026 MVG | Ferro |

The ingredients above are available from the following suppliers:
Makin Metal Powder (UK) Ltd. Buckley Road, Rochdale Lancashire, UK OL12 9DT.
Technic Inc. 1 Spectacle St., Creston, RI 02910 USA
Safina, a.s. Videnska 104, 252 50 Vestec Czech republic
AEE: Atlantic Equipment Engineers 13 Foster St. Bergenfield, NJ 07621
Ames Advanced Materials Corporation 3900 South Clinton Ave. South Plainfield, NJ 07080
CNPC Powder Group Co., Ltd., Room 1211, No. 8 Office Bldg., Wanda Plaza, 58 He Xuan Road, Shanghai, China 201803
Base - Cuprous oxide from JT Baker/Avantar Performance Materials; As received powder - coarse (d50) but information not available.

**Table 5. Electrical and Mechanical Properties for the conductive thick film stack (paste C on paste B) after sintering**

| Thick film stack (paste C/Paste B/substrate) | | | |
|---|---|---|---|
| **Su bstrate** | **Silicon Nitride** | **Aluminum Nitride** | **Alumina** |
| **Sheet resistivity (mOhm/square)** | 3.1 | 3.1 | 3.0 |
| **Initial adhesion (lb. force)** | 8.1 | 5.7 | 5.6 |
| **Aged adhesion (lb. force)** | 7 | 6.8 | 6.3 |

The Invention is further defined by the following Items.

Item A-1. A lead-free and cadmium-free conductive thick film paste comprising in wt.%:
(a) from about 20 to about 49% of a first Cu,
(b) from about 20 to about 34% of a second Cu,
(c) from about 3 to about 12% Cu2O,
(d) from about 8 to about 25% Ag, and
(e) from about 8 to about 25% at least one metal element selected from Ti, V, Zr, Mn, Cr, Co, and Sn,
wherein the first Cu has D50 of about 0.1 to 8 microns, preferably 0.5 to 5 microns, and the second Cu has D50 of about 10 to 20 microns, preferably 12-20 microns.

Item A-2. The thick film paste of item A-1, wherein the thick film paste comprises:
(a) from about 21 to about 36% of the first Cu,
(b) from about 20 to about 30 of the second Cu,
(c) from about 3 to about 12% Cu2O,
(d) from about 8 to about 20% Ag, and
(e) from about 8 to about 20% at least one metal element selected from Ti, V, Zr, Cr, and Sn.

Item A-3. The thick film paste of item A-1 or item A2, wherein the thick film paste comprises:
(a) from about 23 to about 29% first Cu,
(b) from about 20 to about 25% second Cu,
(c) from about 4 to about 9% Cu2O,
(d) from about 8 to about 17% Ag, and
(e) from about 10 to about 16% at least a metal element selected from Ti, and Sn.

Item A-4. The thick film paste of any of items A-1 or A-2 or A-3, further comprising an organic components portion, the paste comprising by weight from about 10 to about 20% organic components portion.

Item B-1. A lead-free and cadmium-free conductive thick film paste comprising a glass component and a copper (Cu) component, the glass component in wt.% comprising:
(a) from about 10 to about 70%, preferably about 15 to about 65%, more preferably about 20 to about 60 % of at least one alkaline earth oxide,
(b) from about 0.01 to about 10%, preferably about 0.1 to about 8%, more preferably about 1 to about 8% of at least one alkali oxide,
(c) from about 22 to about 70%, preferably about 25 to about 65%, more preferably about 25 to about 65% (B2O3 + SiO2), and
(d) from about 0.01 to about 15%, preferably about 0.1 to about 13%, More preferably about 0.5 to about 12% Al2O3,

wherein the alkaline earth oxide is selected from the group consisting of MgO, CaO, SrO, BaO, and ZnO; and the alkali oxide is selected from the group consisting of Li₂O, Na2O, K2O, and Rb2O; and
the Cu component in wt.% comprising:
   (a) from about 14 to about 23% first Cu,
   (b) from about 20 to about 28% second Cu,
   (c) from about 15 to about 24% third Cu, and
   (d) from about 5 to about 11% Cu2O,
wherein D50 of the first Cu is about 5 micron, D50 of the second Cu is about 1.5 micron, D50 of the third Cu is about 10 micron, and
wherein the glass and Cu components are present in a weight ratio of about 1:15 to about 1:30.

Item B-2. The thick film paste of item B-1, wherein the alkaline earth oxide is selected from MgO, CaO, and ZnO.

Item B-3. The thick film paste of item B-2 or item B-2, wherein the alkaline earth oxide is selected from CaO, and ZnO.

Item B-4. The thick film paste of any of items B-1, B-2 or B-3, wherein D50 of the glass component is from about 0.5 to about 20 micron.

Item B-5. The thick film paste of any of items B-1, B-2, B-3, or B-4 wherein the Cu comprises in wt.%:
(a) from about 15 to about 23% the first Cu,
(b) from about 22 to about 28% the second Cu,
(c) from about 17 to about 24% the third Cu, and
(d) from about 6 to about 10% Cu2O.

Item B-6. The thick film paste of item B-1, wherein the Cu comprises in wt.%:
(a) from about 17 to about 22% the first Cu,
(b) from about 23 to about 26% the second Cu,
(c) from about 18 to about 24% the third Cu, and
(d) from about 7 to about 10% Cu2O.

Item B-7. The thick film paste of item B-1, further comprising a organic components portion, the paste comprising by weight from about 10 to about 30% organic components portion.

Item C-1. A method of forming a fired conductive thick film on a substrate comprising:
(a) applying at least one of the conductive thick film paste of any of items A-1 through A-4 and the conductive thick film paste of any of items B-1 through B-7 to form a conductive thick film on the substrate,
(b) drying the conductive thick film paste of any of items A-1 through A-4, and the conductive thick film paste any of items B-1 through B-7, and
(c) firing the dried conductive thick film paste of any of items A-1 through A-4, and the conductive thick film paste any of items B-1 through B-7 to form a fired conductive thick film on the substrate, wherein the firing is conducted in an N2 atmosphere,
wherein the substrate is selected from the group consisting of aluminum oxide, aluminum nitride, and silicon nitride.

Item C-2. The method of item C-1, wherein the at least one of the conductive thick film paste of any of items A-1 through A-4, and the conductive thick film paste any of items B-1 through B-7 is applied by one selected from the group consisting of additive manufacturing, screen printing, syringe deposition, and digital printing technique.

Item C-3. The method of item C-1 or C-2, wherein the firing is conducted at a temperature of from about 850 to about 1050 °C.

Item C-4. The method of any of items C-1 through C-3, wherein the firing is conducted at a temperature of from about 850 to about 900 °C.

Item C-5. The method of any of items C-1 through C-4, wherein the atmosphere contains less than 10 parts per million (ppm) oxygen.

Item C-6. The method of any of items C-1 through C-4, wherein the firing is conducted in a reducing atmosphere.

Item C-7. The method of any of items C-1 through C-6, wherein the reducing atmosphere comprises nitrogen (N2).

Item D-1. An electronic device comprising:
(a) a substrate, and
(b) a lead-free and cadmium-free conductive thick film disposed on at least a portion of the substrate, the lead-free and cadmium-free conductive thick film comprising at least a first conductive thick film and a second conductive thick film,

wherein the substrate is selected from the group consisting of aluminum oxide, aluminum nitride, and silicon nitride, and
wherein the first conductive thick film comprises the conductive thick film paste of item A-1, and the second conductive thick film comprises the conductive thick film paste of any or items A-1 through A-4 or items B-1 through B-7.

Item D-2. The electronic device of item D-1, wherein an interface comprising nitrogen is formed between the substrate and the lead-free and cadmium-free conductive thick film.

Item D-3. The electronic device of item D-1 or item D-2, wherein the interface further comprises Ti.

Item D-4. The electronic device of any of items D-1 through D-3, wherein the first conductive thick film is disposed directly on the substrate.

Item D-5. The electronic device of any of items D-1 through D-4, wherein the second conductive thick film is disposed on the first conductive thick film.

Item D-6. The electronic device of any of items D-1 through D-5, wherein the lead-free and cadmium-free conductive thick film is formed by firing at a temperature of from about 850 to about 1050 °C.

It will be appreciated that although in the previous Examples the substrates employed were limited to silicon nitride, aluminum nitride and alumina, the thick film pastes of the present invention may be utilized in conjunction with a variety of substrates, including but not limited to porcelain enamel coated steel, beryllia substrates, glass substrates, barium titanate substrates, silicon substrate, boron nitride substrate, and silicon carbide substrates. Additionally, it will be appreciated that in addition to the screen printing technique utilized in the previous Examples, the thick film pastes of the present invention may be applied using a variety of additional techniques known in the art including spraying, brushing, dipping, ink-jet or doctor blade.

It will also be appreciated that the term "glass" as used herein is intended to be afforded a broad interpretation and thus it encompasses both glasses, and glass-ceramics that display some degree of crystallization.

Additional advantages and modifications will readily occur to those skilled in the art. Therefore, the invention in its broader aspects is not limited to the specific details and illustrative examples shown and described herein. Accordingly, various modifications may be made without departing from the spirit or scope of the general inventive concept as defined by the appended claims and their equivalents.

### SUMMARY

The present invention is summarized by the following items:
1. A thick film paste comprising in wt.%:
   (a) from about 20 to about 49% of a first Cu,
   (b) from about 20 to about 34% of a second Cu,
   (c) from about 3 to about 12% Cu₂O,
   (d) from about 8 to about 25% Ag,
   (e) from about 8 to about 25% at least one metal element selected from Ti, V, Zr, Mn, Cr, Co, and Sn, and
   (f) no lead and no cadmium,
   wherein the first Cu has D50 of about 0.1 to 8 microns, preferably 0.5 to 5 microns, and the second Cu has D50 of about 10 to 20 microns, preferably 12 to 20 microns.
2. The thick film paste of item 1, wherein the thick film paste comprises:
   (a) from about 21 to about 36% of the first Cu,
   (b) from about 20 to about 30 of the second Cu,
   (c) from about 3 to about 12% Cu₂O,
   (d) from about 8 to about 20% Ag, and
   (e) from about 8 to about 20% at least one metal element selected from Ti, V, Zr, Cr, and Sn.
3. The thick film paste of item 1, wherein the thick film paste comprises:
   (a) from about 23 to about 29% first Cu,
   (b) from about 20 to about 25% second Cu,
   (c) from about 4 to about 9% Cu₂O,
   (d) from about 8 to about 17% Ag, and
   (e) from about 10 to about 16% at least a metal element selected from Ti, and Sn.
4. The thick film paste of item 1, further comprising from about 10 to about 20% of an organic components portion.
5. A lead-free and cadmium-free conductive thick film paste comprising a glass component and a copper component,
   the glass component in wt.% comprising:
      (a) from about 10 to about 70%, preferably about 15 to about 65%, more preferably about 20 to about 60 % of at least one alkaline earth oxide,
      (b) from about 0.01 to about 10%, preferably about 0.1 to about 8%, more preferably about 1 to about 8% of at least one alkali oxide,
      (c) from about 22 to about 70%, preferably about 25 to about 65%, more preferably about 25 to about 65% (B₂O₃ + SiO₂), and
      (d) from about 0.01 to about 15%, preferably about 0.1 to about 13%, more preferably about 0.5 to about 12% Al₂O₃,
         wherein the alkaline earth oxide is selected from the group consisting of MgO, CaO, SrO, BaO, and ZnO; and the alkali oxide is selected from the group consisting of Li₂O, Na₂O, K₂O, and Rb₂O; and
   the Cu component in wt.% comprising:
      (a) from about 14 to about 23% first Cu,
      (b) from about 20 to about 28% second Cu,
      (c) from about 15 to about 24% third Cu, and
      (d) from about 5 to about 11% Cu₂O,
         wherein D50 of the first Cu is about 5 micron, D50 of the second Cu is about 1.5 micron, D50 of the third Cu is about 10 micron, and
   wherein the glass and Cu components are present in a weight ratio of about 1:15 to about 1:30.
6. The thick film paste of item 5, wherein the alkaline earth oxide is selected from MgO, CaO, and ZnO.
7. The thick film paste of item 5, wherein the alkaline earth oxide is selected from CaO, and ZnO.
8. The thick film paste of item 5, wherein D50 of the glass component is from about 0.5 to about 20 micron.
9. The thick film paste of item 5, wherein the Cu comprises in wt.%:
   (a) from about 15 to about 23% the first Cu,
   (b) from about 22 to about 28% the second Cu,
   (c) from about 17 to about 24% the third Cu, and
   (d) from about 6 to about 10% Cu₂O.
10. The thick film paste of item 5, wherein the Cu comprises in wt.%:
   (a) from about 17 to about 22% the first Cu,
   (b) from about 23 to about 26% the second Cu,
   (c) from about 18 to about 24% the third Cu, and
   (d) from about 7 to about 10% Cu₂O.
11. The thick film paste of item 5, further comprising from about 10% to about 30% by weight of an organic components portion.
12. A method of forming a fired conductive thick film on a substrate comprising:
   (a) applying at least one thick film paste according to claim 1 to the substrate to form a thick film on the substrate,
   (b) drying the thick film to form a dried conductive thick film, and
   (c) firing the dried conductive thick film to form a fired conductive thick film on the substrate, wherein the firing is conducted in an N₂ atmosphere,
   wherein the substrate is selected from the group consisting of aluminum oxide, aluminum nitride, and silicon nitride.
13. The method of item 12, wherein the at least one of the conductive thick film paste of claim 1, and the conductive thick film paste of claim 5 is applied by one selected from the group consisting of additive manufacturing, screen printing, syringe deposition, and digital printing technique.
14. The method of item 12, wherein the firing is conducted at a temperature of from about 850 to about 1050 °C.
15. The method of item 12, wherein the firing is conducted at a temperature of from about 850 to about 900 °C.
16. The method of item 12, wherein the atmosphere contains less than 10 ppm O₂.
17. The method of item 12, wherein the firing is conducted in a reducing atmosphere.
18. The method of claim 12, wherein the reducing atmosphere comprises N₂.
19. An electronic device comprising:
   (a) a substrate, and
   (b) a lead-free and cadmium-free conductive thick film disposed on at least a portion of the substrate, the lead-free and cadmium-free conductive thick film comprising at least a first conductive thick film and a second conductive thick film,

   wherein the substrate is selected from the group consisting of aluminum oxide, aluminum nitride, and silicon nitride, and
   wherein the first conductive thick film comprises the conductive thick film paste of claim 1, and the second conductive thick film comprises the conductive thick film paste of claim 1.
20. The electronic device of item 19, wherein an interface comprising nitrogen is formed between the substrate and the lead-free and cadmium-free conductive thick film.

## Claims

1. A lead-free and cadmium-free conductive thick film paste comprising a glass component and a copper component,
the glass component in wt.% comprising:
(a) from about 10 to about 70% of at least one alkaline earth oxide,
(b) from about 0.01 to about 10% of at least one alkali oxide,
(c) from about 22 to about 70% (B₂O₃ + SiO₂), and
(d) from about 0.01 to about 15% Al₂O₃,
wherein the alkaline earth oxide is selected from the group consisting of MgO, CaO, SrO, BaO, and ZnO; and the alkali oxide is selected from the group consisting of Li₂O, Na₂O, K₂O, and Rb₂O; and
the Cu component in wt.% comprising:
(a) from about 14 to about 23% first Cu,
(b) from about 20 to about 28% second Cu,
(c) from about 15 to about 24% third Cu, and
(d) from about 5 to about 11% Cu₂O,
wherein D50 of the first Cu is about 5 micron, D50 of the second Cu is about 1.5 micron, D50 of the third Cu is about 10 micron, and
wherein the glass and Cu components are present in a weight ratio of about 1:15 to about 1:30.

2. The thick film paste of claim 1, wherein the alkaline earth oxide is selected from MgO, CaO and ZnO.

3. The thick film paste of claim 1, wherein the alkaline earth oxide is selected from CaO, and ZnO.

4. The thick film paste of claim 1, wherein D50 of the glass component is from about 0.5 to about 20 micron.

5. The thick film paste of claim 1, wherein the Cu comprises in wt.%:
(a) from about 15 to about 23% the first Cu,
(b) from about 22 to about 28% the second Cu,
(c) from about 17 to about 24% the third Cu, and
(d) from about 6 to about 10% Cu₂O.

6. The thick film paste of claim 1, wherein the Cu comprises in wt.%:
(a) from about 17 to about 22% the first Cu,
(b) from about 23 to about 26% the second Cu,
(c) from about 18 to about 24% the third Cu, and
(d) from about 7 to about 10% Cu₂O.

7. The thick film paste of claim 1, further comprising from about 10% to about 30% by weight of an organic components portion.
